# EUROPEAN PATENT APPLICATION

(11) **EP 0 948 041 A2**
(43) Date of publication of application: **06.10.1999**
(21) Application number: 99104477.7
(22) Date of filing: 05.03.1999
(51) Int. Cl.: H01L 21/336, H01L 21/266, H01L 29/78, H01L 27/092

(54) **Insulated gate transistor, a method of manufacturing same, and semiconductor integrated circuit device**

(30) Priority: 30.03.1998 JP 8320498
(71) Applicant: Hitachi, Ltd., Chiyoda-ku, Tokyo 101-8010 (JP)
(72) Inventor: Ohyanagi, Takasumi, Hitachi-shi, Ibaraki 319-1225 (JP); Amishiro, Masatsugu, Hitachi-shi, Ibaraki 316-0025 (JP); Watanabe, Atsuo, Hitachioota-shi, Ibaraki 313-0013 (JP)
(74) Representative: Strehl Schübel-Hopf & Partner

(57) **Abstract**

When an element having a high withstand voltage and MOS transistor having a low withstand voltage are mounted on a same chip simultaneously, a punch-through is prevented by controlling a threshold voltage of the low withstand voltage field effect transistor.

In source /drain regions of the low withstand voltage p-channel MOS transistor, an interval in the semiconductor layer between the deepest point of a portion contacting with the source region and the deepest point of a portion contacting with the drain region is equal to or longer than gate length of the gate electrode.

Deterioration of characteristics accompanied with punch-through can be prevented.

## Description

### BACKGROUND OF THE INVENTION

The present invention relates to insulated gate transistors such as MOS transistor and the like, a method of manufacturing same, and semiconductor integrated circuit device.

In accordance with conventional p-channel MOS transistor, p-type impurities are implanted into the vicinity of surface of a semiconductor substrate, which becomes a channel region, by ion implantation method. The p-type impurity implantation is aimed mainly at setting a threshold voltage of element at a desired value. Generally, in order to form a shallow p-type impurity layer directly under a gate oxide film, ion implantation of p-type impurities are performed on whole surface of p-channel MOS transistor forming region, and subsequently, gate oxide film and gate electrodes are formed.

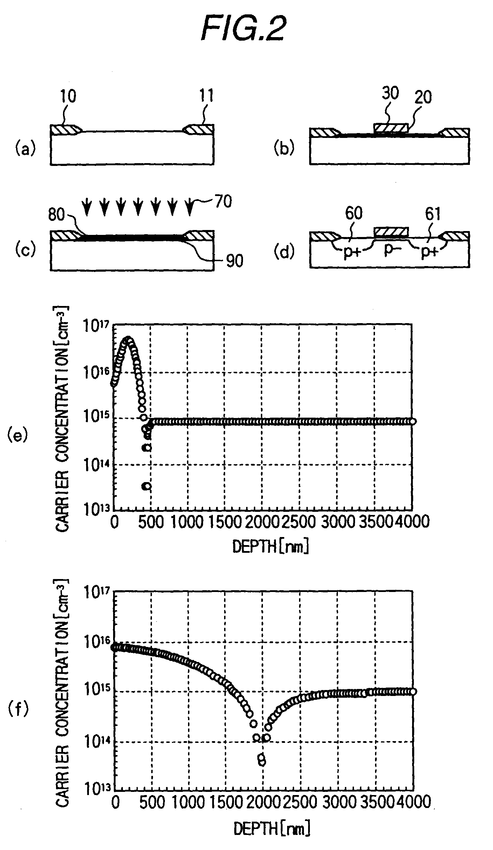

A manufacturing method of p-channel MOS transistor using n-type silicone substrate is indicated in FIG. 2 as an example of conventional processes. First, in accordance with publicly well known manufacturing process of the MOS transistor as indicated in FIG. 2 (a), LOCOS oxide film 10, 11 are formed on the n-type silicone substrate. Then, as indicated in FIG. 2 (b), thermal oxide film 80 is formed thinly, and p-type impurity layer 90 is formed by implanting p-type impurity ions (B+, or BF2+, and the like) 70 into whole surface of the silicone substrate by approximately 10¹² - 10¹⁴ cm⁻² with 10 - tens keV. Then, as indicated in FIG. 2 (c), after removing all the thermal oxide film 80 formed in FIG. 2(b), gate oxide film 20 and gate electrode 30 are formed by the publicly well known manufacturing process of the MOS transistor, and p-channel MOS transistor indicated in FIG. 2 (d) can be obtained by forming source/drain regions by the ion implantation method. FIG. 2(e) is a graph indicating a concentration distribution of boron ions in a depth direction under the gate oxide film 80, when the boron ions are implanted with a dose of 1 x 10¹² cm⁻² by an acceleration energy of 60 keV.

On the other hand, when high withstand voltage elements having a withstand voltage of approximately 80V or more and low withstand voltage MOS transistors having a withstand voltage of such as 5V, 3.3V, 2.5V, and the like are mounted on a chip concurrently, deep junction is required for the impurity layer for forming channel of the high withstand voltage element, and exact location is required for diffusion region. Therefore, after forming the gate oxide film and the gate electrode, the location of the impurity layer is determined in a self-adjusting method relating to the gate electrode, and a heat treatment is performed for a long time. At that time, if the shallow p-type impurity layer for controlling a threshold voltage of the low withstand voltage MOS transistor is formed before forming the gate oxide film and gate electrode as in a conventional manner, the shallow p-type impurity layer is diffused by a high temperature treatment for the high withstand voltage element. FIG. 2 (f) is a graph indicating a concentration distribution of boron ions in a depth direction under the gate oxide film 20 as an example, when the boron ions are implanted with a dose of 1 x 10¹² cm⁻² by an acceleration energy of 60 keV before forming the gate oxide film and the gate electrode , and subsequently, a heat treatment at 1100°C for 360 minutes is performed for forming the channel layer of the high withstand voltage element. In comparison with the FIG. 2 (e), it is revealed that the surface concentration, which determined the threshold voltage of the MOS transistor, is decreased. As the result, the threshold voltage of the MOS transistor can not be controlled. However, if the implantation dose is increased in order to increase the surface concentration, the junction depth of the p-type diffusion layer becomes deep, and the p-type diffusion layers of the source region and the drain region are combined, and the MOS transistor becomes inoperable. Therefore, the presence of the high withstand voltage element and the low withstand voltage p-channel MOS transistor concurrently on a chip becomes possible by utilizing prior art such as the manufacturing method disclosed in JP-A-2-10841 (1990), wherein p-type impurities are introduced so as to penetrate the gate electrode and the gate oxide film after forming the gate electrode.

In accordance with the above prior art, the size of the element of low withstand voltage p-channel MOS transistor is made small so as to realize high integration; that is, if the length of the gate is shortened, depletion layers of source junction and drain junction are contacted; a phenomenon called as punch-through, which means that the current becomes uncontrollable by the gate; and a problem that the p-channel MOS transistor becomes inoperable is generated.

### SUMMARY OF THE INVENTION

The present invention is achieved in consideration of the above problem of the prior art described above, and aimed at providing a structure and a manufacturing method of insulated gate transistor suitable for integrating high withstand voltage elements and low withstand voltage insulated gate transistors on a chip simultaneously.

The insulated gate transistor in accordance with the present invention comprises; second conductive type source region and drain region provided on surface of a substrate of first conductive type semiconductor; and gate electrodes provided on surface of the substrate of the semiconductor via an insulating film at a region located between the source region and the drain region. Furthermore, the second conductive type semiconductor layers having an impurity concentration lower than that of the source region and the drain region are formed on the surface of the substrate of the semiconductor at the location beneath the gate electrode, and at a region connected with the source region and the drain region and deeper than the source region and the drain region in the substrate of the semiconductor. An interval between the deepest point at the portion connected with the source region and the deepest point at the portion connected with the drain region is set so as to be larger than the gate length of the gate electrode. Here, the first conductive type and the second conductive type are any of p-type and n-type contrary each other.

In accordance with the present invention, the depletion layers in the semiconductor substrate are scarcely contacted each other at the region formed deeper than the source region and the drain region in the second semiconductor layer, because the interval between the deepest point at the portion connected with the source region and the deepest point at the portion connected with the drain region is set so as to be larger than the gate length of the gate electrode. Therefore, deterioration of characteristics and impossibility of operation of the semiconductor accompanied with contact of the depletion layers can be prevented. The advantages of the present invention are significant when the channels are shortened by decreasing the gate length, and deterioration accompanied with shortening the channels can be prevented.

The insulated gate transistor described above is manufactured by the following method. The manufacturing method in accordance with the present invention comprises the steps of the first process for forming the gate oxide film and the gate electrode on the surface of the semiconductor substrate, the second process for applying resist or providing insulating member on side wall of the gate electrode, and the third process for implanting ions of the second conductive type impurity in the semiconductor substrate using the gate oxide film, the gate electrode, and the resist or the insulating member as masks so that the impurity is introduced into the surface of the semiconductor substrate located beneath the gate electrode. The second conductive type impurity is introduced deepest into the regions of the semiconductor substrate, where are not masked with the gate electrode, at both sides of the gate electrode, respectively, but the depth of the introduction of the second conductive type impurity in the region of the semiconductor substrate coated with the resist or the insulating member at the side wall of the gate electrode is depressed. Therefore, subsequent to the third process for forming the second conductive type source region and the drain region, the interval between the deepest point of the second conductive type semiconductor layer formed in the second process in the region contacting with the source region and the deepest point in the region contacting with the drain region becomes longer than the length of the gate of the source electrode.

The present invention relates to a semiconductor integrated circuit device comprising fine insulated gate transistor having small gate length, and its manufacturing method is suitable for applying to the semiconductor integrated circuit device including a high temperature thermal treatment such as a case when high withstand voltage semiconductor elements exist simultaneously. That is, in a case when high energy ions for adjusting a threshold voltage are implanted using the gate electrode as a mask after the heat treatment by proving the insulated member at the side wall of the gate electrode, deterioration in the characteristics of the insulated gate transistor; accompanied with contact of the depletion layers between the layers of the semiconductors formed deeply in the regions of the semiconductor substrate, where are not masked with the gate electrode, at both sides of the gate electrode; can be prevented. The advantages of the present invention are significant on the semiconductor integrated circuit device comprising the insulated gate transistor having short gate length and the semiconductor elements having a high withstand voltage, and deterioration of the characteristics of the fine insulated gate transistor can be prevented.

### BRIEF DESCRIPTION OF THE DRAWINGS

FIG. 1 is a schematic cross sectional view of p-channel MOS transistor of the embodiment of the present invention,
FIG. 2 is a set of drawings indicating a conventional manufacturing method of low withstand voltage p-channel field effect transistor, and graphs indicating concentration distribution of p-type impurity in the channel region,
FIG. 3 is a set of graphs indicating the concentration distribution of boron ions in the source/drain regions,
FIG. 4 is a set of graphs indicating a relationship between the effective channel length of the MOS transistor, and a relationship between the effective channel length and ratio of the junction depth,
FIG. 5 is a set of drawings indicating the manufacturing method of the p-channel MOS transistor of the second embodiment of the present invention,
FIG. 6 is a set of drawings indicating the manufacturing method of the p-channel MOS transistor of the third embodiment of the present invention,
FIG. 7 is a set of drawings indicating the manufacturing method of the p-channel MOS transistor of the fourth embodiment of the present invention,
FIG. 8 is a set of drawings indicating the manufacturing method of the p-channel MOS transistor of the fifth embodiment of the present invention, and
FIG. 9 is a set of drawings indicating the manufacturing method of the p-channel MOS transistor of the sixth embodiment of the present invention.

### DETAILED DESCRIPTION OF THE PREFERRED EMBODIMENTS

### (Embodiment 1)

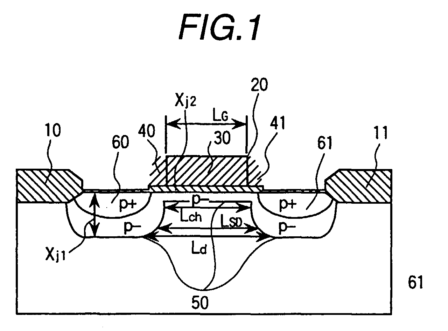

FIG. 1 is a schematic cross sectional view of p-channel MOS transistor of the embodiment of the present invention. LOCOS oxide films 10, 11 for separating elements are formed on the surface of the n-type semiconductor substrate, and p-type source 60 and drain 61 having a high impurity concentration are formed on the surface of the semiconductor substrate between these LOCOS oxide films. Each of source electrode and drain electrode (not shown in the figure) is connected by ohmic junction to the source 60 and the drain 61, respectively. MOS gate is formed by providing thin gate silicone oxide film 20 and polysilicon gate electrode 30 laminated thereon onto the surface of the semiconductor substrate to be channel region between the source 60 and the drain 61. The p-type semiconductor layer for adjusting threshold voltage of the MOS gate having a lower impurity concentration than those of the source and the drain is formed in the region from the surface of the semiconductor substrate just beneath the gate electrode 30 to the region contacting with the source 60 and the drain 61 in the semiconductor substrate and deeper region than these semiconductor regions. Only the portion on the surface of the semiconductor substrate just beneath the gate electrode 30 of the p-type semiconductor layer 50 has substantially a function to adjust the threshold voltage. However, in accordance with forming the p-type semiconductor layer 50 to the region where the source 60 and the drain 61 are located, the threshold voltage adjustment by the ion implantation using the gate electrode as a mask becomes possible as stated later. In the present embodiment, the interval between the region contacting with the source 60 and the region contacting with the drain in the p-type semiconductor layer 50, that is, the distance between source and drain as indicated as L_{SD} in the figure is broadened as it goes deeper from the surface of the semiconductor substrate, and the interval L_{d} at the deepest point becomes larger than the width of the gate electrode 30, that is, the gate length L_{G}. Therefore, generation of punch-through of the depletion layers between the source and the drain becomes difficult, and operation of the p-channel MOS transistor becomes sufficiently possible, even if the gate length is as shortened as equal to or less than 2 µm.

In order to broaden the L_{SD} as it goes deeper from the surface of the semiconductor substrate, insulating films 40, 41 made of silicon oxide are provided at the side wall of the gate electrode 30. the silicon oxide is formed being adhered to the side wall of the gate electrode 30 extending along the side wall to the portion off the end of the gate electrode of the gate oxide film 20. In accordance with the composition of the element having the insulating films 40, 41, the p-type semiconductor layer 50 such as the present embodiment can be formed by ion implantation using the gate electrode 30 as a mask as stated later.

In accordance with the present embodiment, adjustment of the threshold voltage by ion implantation using the gate electrode as the mask becomes possible, and channel shortening becomes possible even if the p-type semiconductor layer 50 has a portion deeper than the source 60 and the drain 61. Accordingly, in accordance with the present embodiment, the p-channel MOS transistor having short channel and the semiconductor element having a high withstand voltage (for instance, IGBT) can be integrated on a same semiconductor chip as explained later in the embodiment.

The conditions for the composition of the present embodiment operating certainly as the p-channel MOS transistor studied by the inventors of the present invention are explained hereinafter.

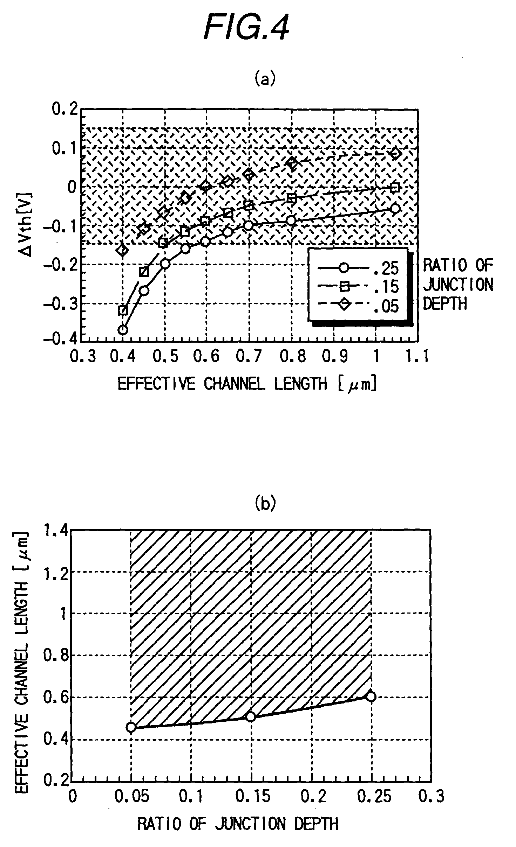

A result of simulation study on variation of the threshold value is indicated in FIG. 4(a); when effective channel length (a distance between the source and the drain L_{CD} under the gate oxide film, that is, the width of the p-type semiconductor layer 50 under the gate oxide film in a direction of the gate length) is varied using the ratio of the p-channel MOS transistor having a junction depth xⱼ₁ of the p-type semiconductor layer 50 contacting with the source and drain in the range of approximately 3000-6000 Å to the junction depth xⱼ₂ of the p-type semiconductor layer 50 under the gate oxide film as a parameter. When the ratio of the junction depth (xⱼ₂ /xⱼ₁) of the p-type semiconductor layer 50 becomes larger than 0.25, the composition does not operate as the MOS transistor, nor the threshold voltage can be determined. When the ratio is smaller than 0.05, the threshold voltage can not be controlled. Generally, the MOS transistor is designed so that the threshold voltage varies in the range of ±0.15 V, in order to depress the variation of the threshold voltage depending on the temperature change, and variation in drain current depending on the elevation of the threshold voltage. Therefore, in accordance with the FIG. 4 (a), the critical effective channel length off the range of ±0.15 V is determined, and a relationship between the ratio of junction depth of the p-type semiconductor layer 50 and the critical effective channel length off the range of ±0.15 V is determined. The result is indicated in FIG. 4 (b). The p-channel MOS transistor operates certainly, if the ratio of the junction depth and the effective channel length of the transistor are in the region of the hatched area of the FIG. 4(b).

### (Embodiment 2)

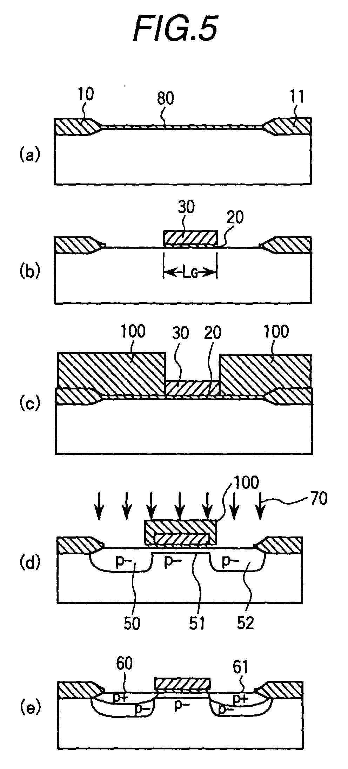

FIG. 5 is a set of the schematic cross sections of the p-channel MOS transistor indicating the steps of the manufacturing method of the second embodiment of the present invention.

As indicated in FIG. 5 (a), LOCOS oxide film 10, 11 are formed on a n-type silicon substrate by a conventional MOS transistor manufacturing method, and a region wherein the MOS transistor is formed is made an active region. Then, as indicated in FIG. 5 (b), gate silicon oxide film 20 is accumulated in a height of tens-hundreds Å by thermal growth method, and n-type polysilicon film 30 is accumulated in a height of hundreds-thousands Å by CVD method. Subsequently, a photoprocess is performed on the gate silicon oxide film 20 and the polysilicon film 30 so as to remain a gate region of gate length 0.5 µm - 2 µm, and unnecessary region is removed by dry etching. Then, as indicated in FIG. 5(c), resist 100 is applied onto the portion other than the polysilicon with the thickness of at least 2 µm so as to be adhered to the side wall of the silicon film in the gate region, and ion implantation is performed on the whole surface of the silicon substrate with p-type impurity ions (B+ or BF2+, and the like) 70 by tens-hundreds keV. After removing the resist applied in the process of FIG. 5 (c), the resist of thousands Å thick is applied onto the upper plane of the polysilicon and a width of hundreds nm to a several microns from the side plane of the polysilicon as indicated in FIG. 5 (d). Here, ion implantation is performed on the whole surface of the silicon substrate with p-type impurity ions (B+ or BF2+, and the like) 70 by tens-hundreds keV. Subsequently, the source/ drain regions 60, 61 of the p-channel MOS transistor are formed by the conventional MOS transistor manufacturing process as indicated in FIG. 5 (e).

In accordance with the ion implantation performed in the process indicated in FIG. 5 (d), the punch-through is suppressed, because the end portion of the source/drain does not reach the beneath portion of the side wall of the gate electrode. Shallow p-type impurity layer 51 is formed exactly beneath the gate electrode by the process indicated in FIG. 5(c), and the threshold voltage of the manufactured p-channel MOS transistor can be controlled to be a desired value.

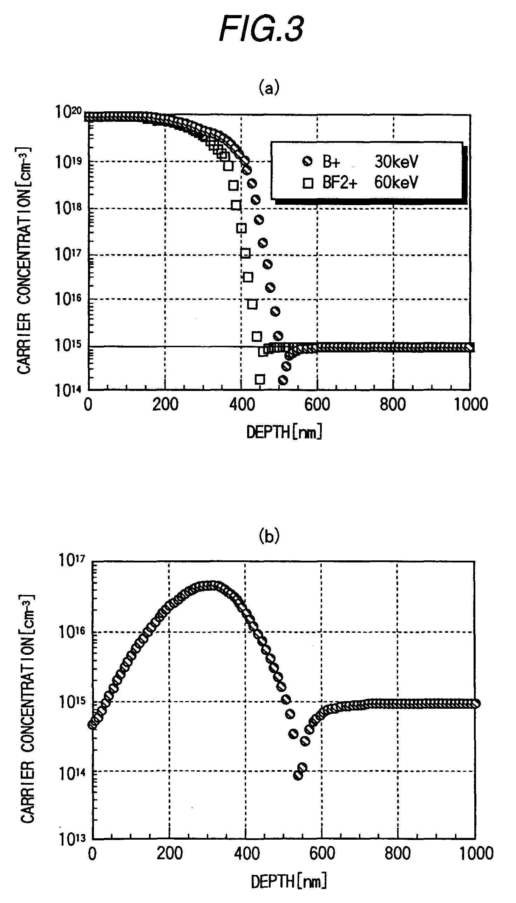

The p-type impurity layers 50, 51, 52 for adjusting the threshold voltage can not form ohmic contact with the source and drain electrodes (not shown in the figure), because the impurity concentration is low. Therefore, p-type impurity is further implanted to be a concentration capable of forming the ohmic contact (generally, at least 1 X 10¹⁵ /cm²) to form the source 60 and the drain 61. Generally, when the fine p-channel MOS transistor is manufactured, the depths of the p-type source and the drain must be shallow as the gate length becomes shorter in order to prevent the contact of the depletion layers. Then, generally, in the process of the gate length of 1.3 µm for instance, the source and the drain are formed by the ion implantation using B+ with 30 keV, and BF2+ with 60 keV. If the gate length is shortened, the same or lower acceleration energy as the above acceleration energy is used. FIG. 3 (a) indicates a concentration distribution of boron ions in a depth direction in a case when the ion implantation is performed with B+ with the acceleration energy of 30 keV, and BF2+ with the acceleration energy of 60 keV, and subsequent conventional processes for recoverying defects and forming interlayer insulating film are performed. When the MOS transistor having the gate length of 1.3 µm is manufactured, the junction depth of the source/drain of a high concentration becomes approximately 450-500 nm.

On the other hand, in order to form the p-type impurity layer 51 just beneath the gate oxide film, the ions must be implanted by the acceleration energy with the surface concentration sufficiently exceeding 1 X 10¹⁶/cm³ for penetrating the gate electrode and the gate oxide film, and adjusting the threshold voltage of the p-channel MOS transistor. The thickness of the gate electrode is approximately 3000-4000 Å for n-type polysilicon in the process of conventional gate length of approximately 1 µm, approximately 1000 Å for n-type polysilicon and approximately 1500 Å for polycide or silicide and the like in the process of gate length of approximately 0.8 µm. Because an indispensable condition for the gate electrode is low resistance, even if the gate length is shortened, significant change in the thickness is not necessary. Thickness of the gate oxide film is approximately 100-300 Å. In a case when the gate oxide film of 250 Å and polysilicon film of 3500 Å are used, which are generally used in the process for gate length of approximately 1.3 µm, an acceleration energy equal to or more than 100 keV is necessary for implanting B+ through the gate oxide film and exceeding the surface concentration of 1 X 10¹⁶ /cm³ sufficiently. In another case when the gate oxide film of 180 Å, and polysilicon film of 1000 Å and silicide of 1500 Å as the gate electrode are used, which are generally used in the process for gate length of approximately 0.8 µm, an acceleration energy equal to or more than 80 keV is necessary for implanting B+. Even if the gate length is shortened, the thickness is not changed significantly, because low resistance is indispensable. Therefore, in order to maintain the surface concentration of exceeding 1 X 10¹⁶ /cm³ sufficiently, an acceleration energy equal to or more than 90 keV is necessary for implanting B+.

FIG. 3(b) is a graph indicating a concentration distribution of B+ in a depth direction of the p-type semiconductor layers 50, 52, which are formed simultaneously with formation of the p-type semiconductor layer 51 by implanting B+ by an acceleration energy of 90 keV. The figure reveals that the junction depth is approximately 550 pm. As indicated in the figure, the p-type semiconductor layers 50, 52 of relatively low concentration exist in positions of the junction depth deeper than the source 60 and the drain 61 of high concentration. With the p-channel MOS transistor having the gate length of equal to or less than 1.3 µm, ensuring a distance between the source and the drain equal to or more than the gate length is necessary at the junction depth position of the low concentration in order to prevent contact of the depletion layers.

In accordance with the present embodiment, ion implantation is performed with applying resist 100 onto the side wall of the gate 30. Therefore, the interval between the p-type semiconductor layers 50, 52, that is the source·drain interval L_{d} at the deepest point shown in FIG. 1, can be made longer than the gate length.

In accordance with the present embodiment, an example of only n-type silicon substrate is indicated. However, the present invention is applicable to any of p-type silicon substrate, SOI substrate, DI separated substrate, and other.

### (Embodiment 3)

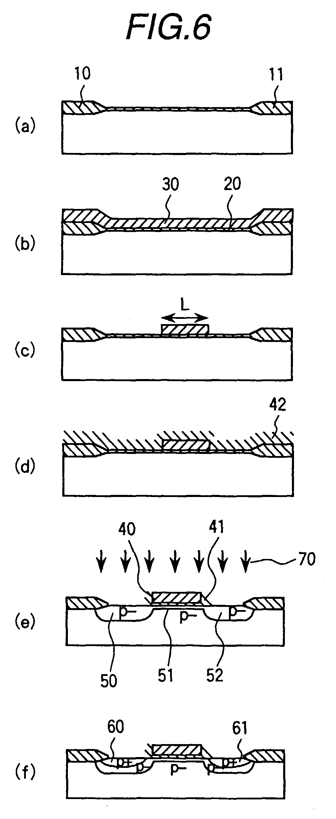

FIG. 6 is a set of the schematic cross sections of the p-channel MOS transistor indicating the steps of the manufacturing method of the third embodiment of the present invention.

As indicated in FIG. 6 (a), LOCOS oxide film 10, 11 are formed on a n-type silicon substrate by a conventional MOS transistor manufacturing method, and a region wherein the MOS transistor is formed is made an active region. Then, as indicated in FIG. 6 (b), gate silicon oxide film 20 is accumulated in a height of tens-hundreds Å by thermal growth method, and n-type polysilicon film 30 is accumulated in a height of hundreds-thousands Å by CVD method. Subsequently, a photoprocess is performed on the gate silicon oxide film 20 and the polysilicon film 30 so as to remain a gate region of gate length 0.5 µm - 2 µm as indicated in FIG. 6(c), and unnecessary region is removed by dry etching. Then, silicon oxide film 42 is accumulated on all the surface of the silicon substrate in a height of thousands Å by CVD method. By performing an anisotropic etching on the accumulated silicon oxide film by dry etching method, the side walls 40, 41 of the silicon oxide film, an insulating material, are remained; the silicon oxide film is adhered to the side planes along the polysilicon film in the gate region until reaching the gate oxide film as indicated in FIG. 6(e). Here, ion implantation is performed on the whole surface of the silicon substrate with p-type impurity ions (B+ or BF2+, and the like) 70 by tens-hundreds keV. Subsequently, the source/ drain regions 60, 61 of the p-channel MOS transistor are formed by the conventional MOS transistor manufacturing process, and the p-channel MOS transistor as indicated in FIG. 6 (f) is obtained.

In accordance with performing the ion implantation of p-type impurity ions through the gate electrode and the gate oxide film, a shallow p-type impurity layer 51 is formed exactly beneath the gate electrode, and the threshold voltage of the manufactured p-channel MOS transistor can be controlled to be a desired value.

In accordance with the present embodiment, an example of only n-type silicon substrate is indicated. However, the present invention is applicable to any of p-type silicon substrate, SOI substrate, DI separated substrate, and other.

### (Embodiment 4)

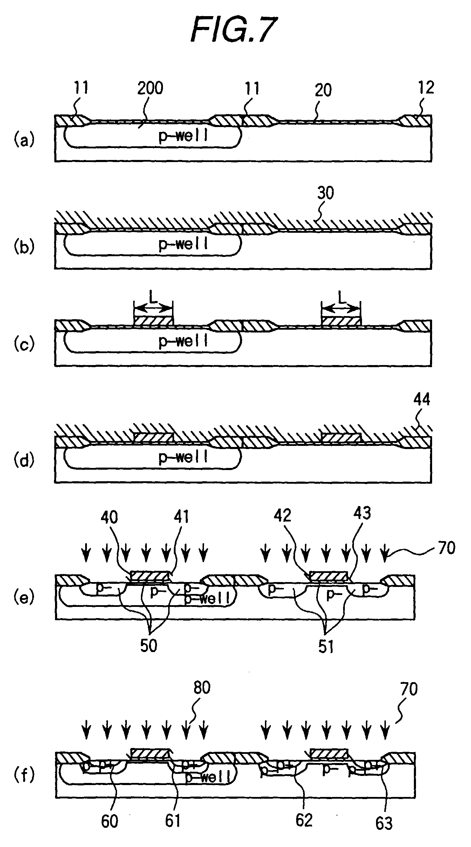

FIG. 7 is a set of the schematic cross sections of semiconductor integrated circuit device, wherein enhancement type n-channel MOS transistors and p-channel MOS transistors are formed on a chip, indicating the steps of the manufacturing method of the fourth embodiment of the present invention.

As indicated in FIG. 7 (a), LOCOS oxide film 10, 11, 12 are formed on a n-type silicon substrate by a conventional MOS transistor manufacturing method, and regions wherein the p-channel and the n-channel MOS transistors are formed are made active regions. In the region, whereon the n-channel MOS transistor is formed, p-well 200 is formed by ion implantation of p-type impurity such as boron ions and the like and heat treatment at a high temperature. Then, as indicated in FIG. 7 (b), gate silicon oxide film 20 is accumulated in a height of tens-hundreds Å by thermal growth method, and n-type polysilicon film 30 is accumulated in a height of hundreds-thousands Å by CVD method. Subsequently, a photoprocess is performed on the gate silicon oxide film 20 and the polysilicon film 30 so as to remain a gate region of gate length 0.5 µm - 2 µm in each of the regions, wherein the n-channel MOS transistor and the p-channel MOS transistor are formed respectively as indicated in FIG. 7(c), and unnecessary region is removed by dry etching. Then, silicon oxide film 44 is accumulated on all the surface of the silicon substrate in a height of thousands Å by CVD method. By performing an anisotropic etching on the accumulated silicon oxide film by dry etching method, the side walls 40, 41, 42, 43 of the silicon oxide film are remained at side planes of the gate silicon oxide film and the polysilicon film. Here, ion implantation is performed on the whole surface of the silicon substrate with p-type impurity ions (B+ or BF2+, and the like) 70 by tens-hundreds keV. Subsequently, p-type source/ drain regions 62, 63 are formed in the region forming the p-channel MOS transistor and n-type source/ drain regions 60, 61 are formed in the region forming the n-channel MOS transistor by the conventional MOS transistor manufacturing process.

In accordance with performing the ion implantation of p-type impurity ions through the gate electrode, shallow p-type impurity layers 50, 51 are formed exactly beneath the gate electrode, and the threshold voltages of both the manufactured p-channel MOS transistor and n-channel MOS transistor can be controlled to be desired values.

In accordance with the present embodiment, an example of only n-type silicon substrate is indicated. However, the present invention is applicable to any of p-type silicon substrate, SOI substrate, DI separated substrate, and other.

### (Embodiment 5)

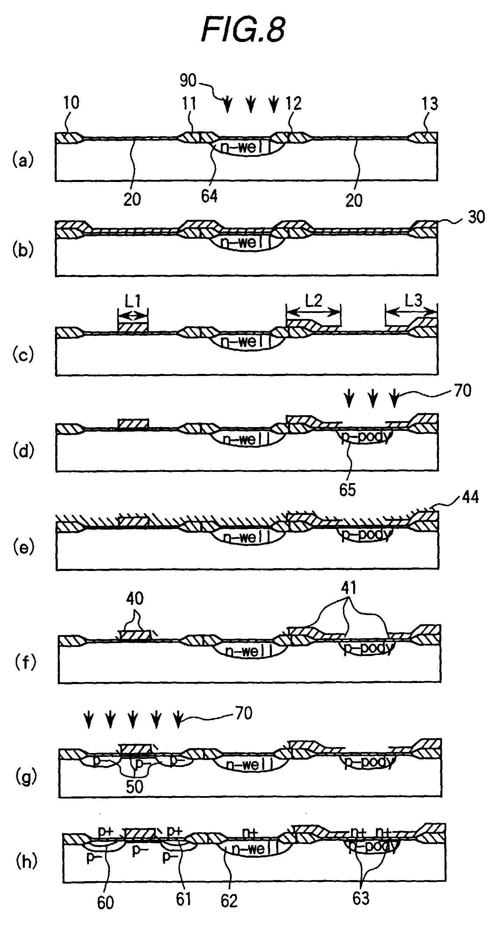

FIG. 8 is a set of the schematic cross sections of semiconductor integrated circuit device, wherein high withstand voltage n-channel MOS transistors and low withstand voltage p-channel MOS transistors are formed on a chip, indicating the steps of the manufacturing method of the fifth embodiment of the present invention.

As indicated in FIG. 8 (a), LOCOS oxide film 10, 11, 12, 13 are formed on a n-type silicon substrate by a conventional MOS transistor manufacturing method, and regions wherein the high withstand voltage n-channel MOS transistors and low withstand voltage p-channel MOS transistors are formed are made active regions. An n-well is formed by ion implantation of n-type impurity 90 such as phosphorus and the like and heat treatment at a high temperature. Then, as indicated in FIG. 8 (b), gate silicon oxide film 20 is accumulated in a height of tens-hundreds Å by thermal growth method, and n-type polysilicon film 30 is accumulated in a height of hundreds-thousands Å by CVD method. Subsequently, a photoprocess is performed on the gate silicon oxide film 20 and the polysilicon film 30 so as to remain gate regions of gate length L2, L3 of several µm for the high withstand voltage n-channel field effect transistor and the gate regions of gate length L1 of 0.5 - 2 µm for the low withstand voltage p-channel field effect transistor, respectively as indicated in FIG. 8(c), and unnecessary region is removed by dry etching. Then, p-type impurity ions (B+ or BF2+ and others) 70 are introduced into only the region of the high withstand voltage n-channel MOS transistor by ion implantation, and deep p-type impurity layer 65 as indicated in FIG. 8 (d) is formed by thermal diffusion process at hundreds to a thousand and several hundreds degrees for tens - several hundreds minutes. Then, silicon oxide film 44 is accumulated on all the surface of the silicon substrate in a height of thousands Å by CVD method. By performing an etching on the accumulated silicon oxide film by dry etching method, the side walls 40, 41, of the silicon oxide film are remained at side planes of the gate silicon oxide film and the polysilicon film as indicated in FIG. 8 (e). Here, ion implantation is performed on only the region of the low withstand voltage p-channel field effect transistor with p-type impurity ions (B+ or BF2+, and the like) 70 by tens-hundreds keV to form the p-type impurity layer 50. Subsequently, n-type source/ drain regions 62, 63 are formed in the region forming the high withstand voltage n-channel MOS transistor and p-type source/ drain regions 60, 61 are formed in the region forming the low withstand voltage p-channel MOS transistor by the conventional MOS transistor manufacturing process.

In accordance with the low withstand voltage p-channel MOS transistor manufactured as above, the ion implantation of p-type impurity ions for adjusting the threshold voltage is performed after completion of the gate electrode. Accordingly, the low withstand voltage p-channel MOS transistor is not influenced by the heat treatment at a high temperature for forming channel stop region of the high withstand voltage n-channel MOS transistor, and the threshold value of the p-channel MOS transistor can be controlled to be a desired value.

In accordance with the present embodiment, an example of only n-type silicon substrate is indicated. However, the present invention is applicable to any of p-type silicon substrate, SOI substrate, DI separated substrate, and other. Furthermore, an embodiment of forming the high withstand voltage n-channel MOS transistor and the low withstand voltage p-channel MOS transistor on a chip is indicated, but high withstand voltage p-channel MOS transistor and the low withstand voltage p-channel MOS transistor can be formed similarly on a chip.

### (Embodiment 6)

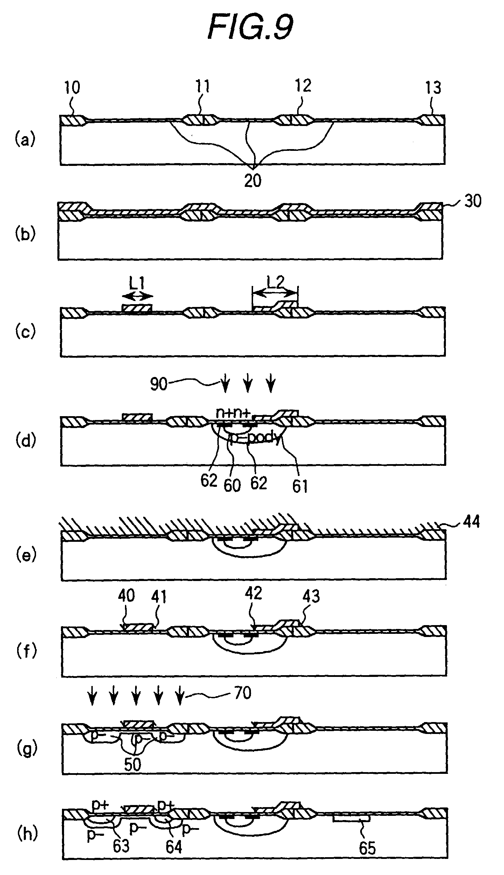

FIG. 9 is a set of the schematic cross sections of semiconductor integrated circuit device, wherein IGBT and p-channel MOS transistors are formed on a chip, indicating the steps of the manufacturing method of the sixth embodiment of the present invention.

As indicated in FIG. 9 (a), LOCOS oxide film 10, 11, 12, 13 are formed on a n-type silicon substrate by a conventional MOS transistor manufacturing method, and regions wherein the field effect transistors and the IGBT are formed are made active regions. Then, as indicated in FIG. 9 (b), gate silicon oxide film 20 is accumulated in a height of tens-hundreds Å by thermal growth method, and n-type polysilicon film 30 is accumulated in a height of hundreds-thousands Å by CVD method. Subsequently, a photoprocess is performed on the gate silicon oxide film 20 and the polysilicon film 30 so as to remain gate regions of gate length L of several µm for the IGBT and the gate regions of gate length L of 0.5 - 2 µm for the low withstand voltage p-channel MOS transistor, respectively as indicated in FIG. 9(c), and unnecessary region is removed by dry etching. Then, p-type impurity ions 90 are introduced into only the region of the IGBT by ion implantation and by thermal diffusion process at hundreds to a thousand and several hundreds degrees for tens - several hundreds minutes for forming the deep p-type impurity layer 61 as indicated in FIG. 9 (d). Subsequently, p-type impurity ions are introduced similarly by ion implantation and thermal diffusion process at hundreds to a thousand and several hundreds degrees for tens - several hundreds minutes for forming the p-type impurity layer 60. Furthermore, ion implantation is performed for forming n-type anode of the IGBT. Then, silicon oxide film 44 is accumulated on all the surface of the silicon substrate in a height of thousands Å by CVD method as indicated in FIG. 9 (e). By performing an etching on the accumulated silicon oxide film by dry etching method, the side walls 40, 41, 423, 43 of the silicon oxide film are remained at side planes of the gate silicon oxide film and the polysilicon film as indicated in FIG. 9 (f). Here, ion implantation is performed on only the region of the low withstand voltage p-channel field effect transistor with p-type impurity ions (B+ or BF2+, and the like) 70 by tens-hundreds keV to form the p-type impurity layer 50. Subsequently, p-type collector 65 is formed for the IGBT, and p-type source/ drain regions 63, 64 are formed for the low withstand voltage p-channel MOS transistor by the conventional IGBT and MOS manufacturing process.

In accordance with the low withstand voltage p-channel MOS transistor manufactured as above, the ion implantation of p-type impurity ions for adjusting the threshold voltage is performed after completion of the gate electrode. Accordingly, the low withstand voltage p-channel MOS transistor is not influenced by the heat treatment at a high temperature for forming channel stop region of the IGBT, and the threshold value of the p-channel MOS transistor can be controlled to be a desired value.

As explained above, the IGBT and the low withstand voltage p-channel MOS transistor can be mounted on a same chip.

In accordance with the present embodiment, an example of only n-type silicon substrate is indicated. However, the present invention is applicable to any of p-type silicon substrate, SOI substrate, DI separated substrate, and other.

As explained above, in accordance with the present invention, the high withstand voltage elements and short channel fine low withstand voltage MOS transistor can be existed simultaneously.

## Claims

1. An insulated gate transistor comprising:
a second conductive type source region and a drain region provided on a first conductive type semiconductor substrate,
a gate electrode provided on surface of said semiconductor substrate at a location between said source region and said drain region via an insulating film, and
a second conductive type semiconductor layer formed on surface of said semiconductor substrate at a location beneath said gate electrode and at a region in the semiconductor substrate contacting with said source region and said drain region, and deeper than said source region and said drain region, wherein
an interval in said semiconductor layer between the deepest point of a portion contacting with said source and the deepest point of a portion contacting with said drain is equal to or longer than gate length of said gate electrode.

2. An insulated gate transistor as claimed in claim 1, wherein
a relationship between a ratio of junction depth in the region located beneath said gate electrode of said semiconductor layer to the junction depth at the deepest point of said semiconductor layer, and a width in gate length direction of the region located beneath said gate electrode of said semiconductor layer is in a relation indicated in FIG. 4 of the present application.

3. An insulated gate transistor as claimed in claim 2, wherein
said ratio is in the range of 0.05 to 0.25.

4. An insulated gate transistor as claimed in claim 1, wherein
an insulating film is provided on side walls of said gate electrode.

5. A semiconductor integrated device comprising:
a semiconductor chip provided with;
said insulated gate transistor as claimed in claim 1, and
a semiconductor element having a withstand voltage higher than said insulated gate transistor.

6. A method of manufacturing insulated gate transistor comprising the steps of:
a first step of forming a gate oxide film and gate electrode on surface of a first conductive type semiconductor substrate,
a second step of applying resist on side walls of said gate electrode,
a third step of implanting ions to said semiconductor substrate using said gate oxide film, said gate electrode, and said resist as masks so that second conductive type impurity is introduced onto surface of said semiconductor substrate at a location beneath said gate electrode, and
a fourth step of forming second conductive type source region and drain region after said third step.

7. A method of manufacturing insulated gate transistor comprising the steps of:
a first step of forming a gate oxide film and gate electrode on surface of a first conductive type semiconductor substrate,
a second step of providing insulating member at side walls of said gate electrode,
a third step of implanting ions to said semiconductor substrate using said gate oxide film, said gate electrode, and said insulating member as masks so that second conductive type impurity is introduced onto surface of said semiconductor substrate at a location beneath said gate electrode, and
a fourth step of forming second conductive type source region and drain region after said third step.

8. A method of manufacturing semiconductor integrated circuit device comprising the steps of:
a first step of forming second conductive type well region on surface of first conductive type semiconductor substrate by heat treatment,
a second step of forming gate oxide film and gate electrode on the first conductive type surface of said semiconductor substrate,
a third step of providing insulating member at side walls of said gate electrode,
a fourth step of implanting ions to said semiconductor substrate using said gate oxide film, said gate electrode, and said insulating member as masks so that second conductive type impurity is introduced onto surface of said semiconductor substrate at a location beneath said gate electrode, and
a fifth step of forming second conductive type source region and drain region after said third step.

9. A method of manufacturing semiconductor integrated circuit device provided with insulated gate transistor and semiconductor element having a withstand voltage higher than said insulated gate transistor comprising the steps of:
a first step of forming second conductive type deep semiconductor region of said semiconductor element on surface of first conductive type semiconductor substrate by heat treatment,
a second step of forming gate oxide film and gate electrode in said insulated gate transistor on the first conductive type surface of said semiconductor substrate,
a third step of providing insulating member at side walls of said gate electrode,
a fourth step of implanting ions to said semiconductor substrate using said gate oxide film, said gate electrode, and said insulating member as masks so that second conductive type impurity is introduced into a region to be said insulated gate transistor of said transistor substrate onto surface of said semiconductor substrate at a location beneath said gate electrode, and
a fifth step of forming second conductive type source region and drain region of said insulated gate transistor after said third step.
